# EUROPÄISCHE PATENTANMELDUNG

(11) **EP 4 375 685 A1**
(43) Veröffentlichungstag der Anmeldung: **29.05.2024**
(21) Anmeldenummer: 22209399.9
(22) Anmeldetag: 24.11.2022
(51) Int. Cl.: G01R 31/367, G01R 31/392

(54) **VERFAHREN ZUM BESTIMMEN DER ALTERUNG EINES BATTERIESPEICHERS, VORRICHTUNG UND COMPUTERPROGRAMMPRODUKT**

(71) Anmelder: Siemens Aktiengesellschaft, 80333 München (DE)
(72) Erfinder: Arzberger, Arno, 96135 Stegaurach (DE); Scheer, Kilian, 96231 Bad Staffelstein (DE); Schricker, Barbara, 91058 Erlangen (DE)
(74) Vertreter: Siemens Patent Attorneys

(57) **Zusammenfassung**

Die Erfindung betrifft ein Verfahren zum Bestimmen der Alterung eines Batteriespeichers umfassend mehrere Schritte:
a) Durchlaufen mindestens zweier Zyklen einer Zyklierung zur Ermittlung von Zuständen, insbesondere der Alterung, des Batteriespeichers zur Messung von Parametern innerhalb der Zyklen in der zeitlich ersten Phase,
b) Manipulieren von durch die über die Zyklen gemessenen Parameter gebildeten Messdaten in einer zweiten Phase derart, dass zumindest ein Teil der Messdaten zumindest eines Teils der Zyklen hinsichtlich von zumindest teilweise mit einer oberen Spannungsgrenze und einer untere Spannungsgrenze korrelierenden, insbesondere die obere Spannungsgrenze und untere Spannungsgrenze selbst, Parameter innerhalb der Zyklen derart verändert werden, dass über alle Zyklen des Teils der Zyklen hinweg ein erster Wert der oberen Spannungsgrenze nahezu nie überschritten und ein zweiter Wert der unteren Spannungsgrenze nahezu nie unterschritten wird,
c) Bilden eines generierten Messdatensatzes für den Teil der Zyklen derart, dass veränderte zumindest teilweise korrelierende Parameter des manipulierten Teils der Messdaten und der nicht manipulierte Teil der Messdaten des Teils der Zyklen zusammengeführt wird,
d) Erzeugung von, die Werte der generierten Messdaten repräsentierenden, Signalen zu einer Verarbeitung unter Nutzung des HPC Verfahrens,
e) Ermittlung der Alterung auf Grundlage der Verarbeitung zumindest der die Werte der generierten Messdaten repräsentierenden Signale.

## Beschreibung

Die Erfindung betrifft ein Verfahren zum Bestimmen der Alterung eines Batteriespeichers gemäß dem Gattungsbegriff des Anspruchs 1, eine Vorrichtung zum Durchführen des Verfahrens gemäß dem Gattungsbegriff des Anspruchs 11 und ein Computerprogrammprodukt gemäß Gattungsbegriff des Anspruchs 12.

Lithium-Ionen-Akkumulatoren, im Folgenden auch Lithium-Ionen-Batterien genannt, werden aufgrund ihrer hohen Leistungs- und Energiedichte in mobilen und stationären Anwendungen als Energiespeicher eingesetzt. Um diese elektrochemischen Energiespeicher sicher, zuverlässig und möglichst lang wartungsfrei betreiben zu können, ist eine möglichst genaue Kenntnis kritischer Betriebszustände, insbesondere hinsichtlich des Ladezustands (engl.: State of Charge, SOC) und hinsichtlich des Alterungszustands (engl: State of Health, SOH), nötig.

Es ist bekannt, dass die Alterung einer Batterie, insbesondere die sogenannte zyklische Alterung durch hohe Temperaturen, das schnelle Laden bei niedrigen Temperaturen, in Abhängigkeit des Ladezustands und der Entladetiefe und der Ladeleistung und Entladeleistung negativ beeinflusst werden kann. Es ist somit möglich, dass derselbe Typ einer Batteriezelle in Abhängigkeit der genannten Parameter eine große unterschiedliche Anzahl von Lastzyklen bewerkstelligen kann.

Zur Bestimmung des erwartbaren Alterungsverlaufs wird im Stand der Technik mittels Messungen während der Auslegungsphase eines Batteriesystems eine Alterungscharakteristik der verwendeten Batteriezelle bestimmt. Die reale Alterungsgeschwindigkeit mit realen Lastprofilen wird häufig nicht getestet. Vielmehr wird in sogenannten Rafftests die Alterungsgeschwindigkeit, oder die Zyklenstabilität, an komprimierten Lastprofilen bestimmt. Mit diesen Ergebnissen werden empirische Alterungsmodelle parametriert, aus welchen der Alterungsverlauf in der Anwendung hervorgeht. Ein basierend auf physikalischen und/oder chemischen Messungen ermittelter Verlauf der zukünftigen Alterung in Abhängigkeit des Lastprofils, des Arbeitspunkts und der Umgebungsbedingungen ist aufgrund der Nichtlinearität der zugrundeliegenden physikalischen und chemischen Prozesse und deren komplexen Wechselwirkungen nur schwer durchzuführen.

Die Vorhersage des Alterungszustands einer Batterie gestaltet sich nachteilig komplex. Häufig ist die Parametrierung eines aussagekräftigen Alterungsmodells somit nachteilig sehr zeitaufwendig. Weiterhin müssen häufig Annahmen zum Bewerten einer Alterung getroffen werden, welche diese nachteilig ungenau machen.

Dies hat nachteilig zur Folge, dass Batteriespeicher größer dimensioniert werden als es die Leistungs- und Lebensdaueranforderungen erfordern, um eine ausreichende Leistung zu gewährleisten und somit Haftungs- und Gewährleistungszusagen einhalten zu können.
- Nach dem Stand der Technik verzweigt sich die Alterung von elektrochemischen Energiespeichern, insbesondere von Li-Ionen Batterien, in zwei grundsätzlich zu unterscheidende Zweige.
- Hinter dem Zweig der "zyklischen" Alterung steht die Beobachtung, dass Li-Ionen Batterien mit jedem Lastzyklus einen Teil ihrer Speicherfähigkeit für elektrische Ladung verlieren. Die Geschwindigkeit, mit der die sog. Restkapazität sinkt, ist abhängig von Lastprofil, Arbeitspunkt und den Umgebungsbedingungen der Batterie.
- Für die Messung der zyklischen Alterung erfolgt nach dem Stand der Technik ein mehrfacher Wechsel aus Checkup-Tests und der sog. Zyklierung. In der Zyklierung werden die Zellen periodisch mit sog. Zyklenprofilen bei unterschiedlichen Umweltbedingungen (z.B. Temperatur, Druck, etc.) beaufschlagt. Die verwendeten Zyklenprofile können Stromprofile oder Leistungsprofile, seltener Spannungsprofile sein. Die typischen Variablen zur Definition der in der Zyklierung periodisch durchlaufenen Profile umfassen insbesondere Stromstärke (C-Rate), elektrische Leistung (CP-Rate), mittleren Ladezustand (SOC) und/oder Entladetiefe (DOD).
- Hinter dem Zweig der "kalendarischen" Alterung steht die Beobachtung, dass Li-Ionen Batterien auch dann altern, wenn sie gar nicht benutzt (ge- und entladen) werden.
- Die Messung der kalendarischen Alterung erfolgt nach dem Stand der Technik in sog. Lagertests. Dabei werden die Zellen bei unterschiedlichen Kombinationen aus Lagertemperatur und Ladezustand (SOC) gelagert. Die Lagerung erfolgt entweder bei offenen Klemmen oder, unter Verwendung eines Potentiostaten, bei konstanter Spannung.
- Zur Ermittlung der Alterungsgeschwindigkeit wird für beide Zweige in regelmäßigen Zeitabständen ein sog. Checkup-Test durchgeführt. Dabei wird die sog. Restkapazität der Zelle, d.h. die unter Standardbedingungen maximal entnehmbare Ladungsmenge, gemessen. Aus dem Verlauf der Ergebnisse wird dann die Alterungsgeschwindigkeit, z.B. für Auslegungszwecke, berechnet.
- Die Ergebnisse sind außerdem Grundlage für die Parametrierung empirischer Alterungsmodelle. Darin wird die Gesamtheit der Ergebnisse durch einen mathematischen Optimierer an ein Modell angenähert.

Zur Reduktion der Komplexität bzw. anderer zuvor genannter Probleme sind Verfahren bekannt, bei denen mit geringem Zeitaufwand das Alterungsverhalten eines Energiespeichers ermittelt werden kann.

Hierunter fällt der Gegenstand der nachveröffentlichten deutschen Patentanmeldung 10 2022 201 676.9, bei der zur Lösung dieser Nachteile ein Verfahren zur Messung einer Alterung eines Batteriespeichers mittels einer Hoch-Präzisions-Coulometrie (HPC) offenbart ist, wobei dort unter dem Batteriespeicher insbesondere ein Lithium-Ionen Akkumulator oder auch eine Lithium-Ionen Batterie zu verstehen ist, der/die insbesondere einer zyklischen und kalendarischen Alterung ausgesetzt ist, wodurch sich über die Lebensdauer des Batteriespeichers seine/ihre maximal nutzbare Kapazität verringert. In dem Verfahren ist eine Sequenz umfassend mehrere Belastungsmuster vorgesehen. Dabei umfasst jedes Belastungsmuster eine Vielzahl von Entlade- und Ladevorgängen mit jeweils definierten Entladungstiefen (DOD), charakteristischen mittleren Ladezuständen (SOC), Stromstärken, Pausenzeiten und/oder Temperaturen.

Gemäß dem Verfahren wird in einem ersten Schritt die Sequenz der mehreren Belastungsmuster durchlaufen, wobei durch die Entlade- und Ladevorgänge bewirkte Kapazitätsverluste (ΔKap) gemessen werden. Ferner wird in einem zweiten Schritt des Verfahrens die Restkapazität des Batteriespeichers bestimmt.

Hierdurch ist ein gegenüber dem Stand der Technik verbesserter Ansatz auf Basis der "High Power Cycling"-Methode bekannt. Bei dieser Methode müssen allerdings, um Alterungsraten aus Messdaten bestimmen zu können, die zugrunde liegenden Daten in der Regel bestimmten Anforderungen genügen.

Die Daten müssen insbesondere eine hohe Messgenauigkeit, beispielsweise eine hohe Messgenauigkeit bzgl. Zeit, Spannung, Strom und Temperatur, aufweisen, und idealerweise nach einer speziellen Messprozedur erzeugt worden sein.

Diese ideale Messprozedur fordert das Zyklieren von Batteriezellen. Zyklieren bedeutet ein wiederholtes Laden und Entladen im Wechsel über einen längeren Zeitraum und innerhalb zweier fester Spannungsgrenzen. Ladestrom, Entladestrom sowie die Umgebungstemperatur müssen dabei konstant gehalten werden.

Nachteilig ist somit auch, dass in Abhängigkeit von der verwendeten Hardware, beispielsweise in der Batterieproduktion, wo keine hochpreisigen Laborgeräte zum Einsatz kommen, in der Praxis die Einhaltung der geforderten Messgenauigkeit und der Ausschluss von störenden Umwelteinflüssen häufig schwierig ist, so dass die beschriebenen Anforderungen an die Messdaten nicht immer erfüllt sind.

Bei der HPC-Methodik wird bei der Messwertaufnahme daher versucht, durch entsprechende Hardware und den komplexen Versuch die Umgebungsbedingungen ideal zu halten, eine spezielle Messprozedur genau einhalten zu können, so dass die gewonnenen Daten direkt mit der HPC-Analyse-Methodik auswertbar sind.

Die der Erfindung zugrundeliegende Aufgabe ist es daher eine technische Lösung anzugeben, die die Nachteile des Standes der Technik löst, insbesondere eine einfache und zuverlässige Methodik zur Bestimmung von Alterungszuständen einer wiederaufladbaren Batterie zu realisieren.

Diese Aufgabe wird durch Verfahren gemäß Gattungsbegriff des Anspruchs 1, durch dessen Merkmale, die Vorrichtung gemäß Gattungsbegriff des Anspruchs 11, durch dessen Merkmale, sowie das Computerprogrammprodukt gemäß Gattungsbegriff des Anspruchs 12 und durch dessen Merkmale, gelöst.

Das erfindungsgemäße Verfahren zum Bestimmen der Alterung eines Batteriespeichers umfasst mehrere Schritte:
a) Durchlaufen mindestens zweier Zyklen einer Zyklierung zur Ermittlung von Zuständen, insbesondere der Alterung, des Batteriespeichers zur Messung von Parametern innerhalb der Zyklen in der zeitlich ersten Phase,
b) Manipulieren von durch die über die Zyklen gemessenen Parameter gebildeten Messdaten in einer zweiten Phase derart, dass zumindest ein Teil der Messdaten zumindest eines Teils der Zyklen hinsichtlich von zumindest teilweise mit einer oberen Spannungsgrenze und einer unteren Spannungsgrenze korrelierenden, insbesondere die obere Spannungsgrenze und untere Spannungsgrenze selbst, Parameter innerhalb der Zyklen derart verändert werden, dass über alle Zyklen des Teils der Zyklen hinweg ein erster Wert der oberen Spannungsgrenze nahezu nie überschritten und ein zweiter Wert der unteren Spannungsgrenze nahezu nie unterschritten wird,
c) Bilden eines generierten Messdatensatzes für den Teil der Zyklen derart, dass veränderte zumindest teilweise korrelierende Parameter des manipulierten Teils der Messdaten und der nicht manipulierte Teil der Messdaten des Teils der Zyklen zusammengeführt werden,
d) Erzeugung von, die Werte der generierten Messdaten repräsentierenden, Signalen zu einer Verarbeitung unter Nutzung des HPC Verfahrens,
e) Ermittlung der Alterung auf Grundlage der Verarbeitung zumindest der die Werte der generierten Messdaten repräsentierenden Signale.

Mit dem erfindungsgemäßen Verfahren werden manipulierte Signale aus Signalen zu Messdaten einer Zyklierung erzeugt, die durch das Hoch-Präzisions-Coulometrie-, HPC-Verfahren nutzbar sind, auch wenn diese Signale aus Messdaten einer Zyklierung stammen, die nicht nach dem HPC-Verfahren bzw. dessen Rahmenbedingungen für eine Zyklierung erzeugt wurden.

Die erfindungsgemäße Vorrichtung umfasst Mittel zum Durchführen des erfindungsgemäßen Verfahrens oder einer der bevorzugten Ausgestaltungen und Weiterbildungen des Verfahrens, insbesondere zumindest ein Modul, zur Durchführung des Verfahrens.

Das erfindungsgemäße Computerprogrammprodukt ist direkt in einen Speicher einer programmierbaren Recheneinheit ladbar, mit Programmcode-Mitteln, um das erfindungsgemäße Verfahren oder eine der bevorzugten Ausgestaltungen und Weiterbildungen des Verfahrens auszuführen, wenn das Computerprogrammprodukt in der Recheneinheit ausgeführt wird.

Dadurch können zur Bestimmung der Alterungsrate von Batterien mit dem HPC-Verfahren auch im Rahmen des erfindungsgemäßen Verfahrens Methoden und deren Messungen verwendet werden, die ursprünglich nicht zu diesem Zweck erzeugt wurden und zu Beginn des erfindungsgemäßen Verfahrens also zunächst nicht die geforderte Genauigkeit aufweisen.

Weitere vorteilhafte Ausgestaltungen und Weiterbildungen der Erfindung sind durch die Unteransprüche angegeben.

Bei einer Weiterbildung des erfindungsgemäßen Verfahrens wird der Teil der Messdaten aus den durch die über die Zyklen gemessenen Parameter gebildeten Messdaten derart abgezweigt, dass ein dem Teil zeitlich vorausgehender, insbesondere aufgrund eines Einschwingens, bezüglich mindestens einem der Parameter hinsichtlich seiner Werte stark schwankender Teil durch die über die Zyklen gemessenen Parameter gebildeten Messdaten ausgenommen wird.

Dies unterstützt die Erfindung dabei das nutzbare Spannungsfenster möglichst groß ausbilden zu können, denn es kann der zeitlich vorausgehende Teil der aufgezeichneten Messdaten aus der Zyklierung, beispielsweise die erste Hälfte oder die ersten zwei Drittel, in der Regel verworfen werden. Im ersten Teil der Messdaten, der hier abgeschnitten wird, befindet sich in der Regel die Zelle eines Batteriespeichers in einem Einschwingverhalten, so dass der letzte Teil der Messung die eigentlich aussagekräftigen Daten liefert. Dies nutzt die Erfindung auf vorteilhafte Weise und trägt dazu bei, die Präzision des Ergebnisses der Bestimmung der Alterungsrate zu steigern.

Eine Möglichkeit die Werte manuell festzulegen ist gegeben, wenn das erfindungsgemäße Verfahren derart weitergebildet wird, dass der erste Wert und der zweite Wert durch die Erfassung einer Nutzereingabe festgelegt werden.

Bevorzugt wird jedoch eine automatische Generierung dieser Werte erfolgen. Dies wird gemäß einer Weiterbildung des erfindungsgemäßen Verfahrens erreicht, bei der der erste Wert und der zweite Wert durch ein die Manipulation durchführendes Modul generiert wird.

In einem derartigen Modul kann schaltungstechnisch die Realisierung der verfahrensgemäßen Manipulation, insbesondere die Festlegung der Spannungsgrenzen erfolgen. Schaltungstechnische Lösungen, die das Modul zumindest teilweise bilden können, sind beispielsweise sogenannte Field Programmable Gate Arrays, als Beispiel eines integrierten Schaltkreises (IC) der Digitaltechnik, in welchen eine logische Schaltung geladen werden kann, auch nicht programmierbare Gatter sind denkbar. Vorzugsweise wird jedoch das Modul zumindest teilweise auf eine zentrale Steuereinrichtung zurückgreifen bzw. diese integrieren, sodass zumindest ein Teil der Erfindung eine Rechnereinheit nutzen kann. Dies erlaubt einen maximalen Freiheitsgrad hinsichtlich Optimierungen, aber auch hinsichtlich der Möglichkeiten der Signalübertragung und/oder -verarbeitung.

Bei einer weiteren Weiterbildung des erfindungsgemäßen Verfahrens erfolgt eine Festsetzung des ersten Wertes und des zweiten Wertes derart, dass sie in Abhängigkeit der gemessenen Temperatur mindestens einer der Zellen des Batteriespeichers, insbesondere individuell für jeden Zyklus, generiert werden.

Hierdurch kann das erfindungsgemäße Verfahren auch angewendet werden, um nachteilige Temperatureinflüsse zu kompensieren, weil durch diese Weiterbildung die Spannungsgrenze für jeden Zyklus individuell gesetzt und an die gemessene Zelltemperatur gekoppelt werden kann. Temperaturbedingte Änderungen in der Überspannung können dadurch ausgeglichen werden.

Das erfindungsgemäße Verfahren kann ferner derart weitergebildet werden, dass die Festlegung in Abhängigkeit der Temperatur zumindest anhand einer eine Abhängigkeit des Gleichstrom-Innenwiderstandes der Zelle von Stromrichtung, von dem SOC und/oder der Temperatur, insbesondere unter Auslesen einer diese Zuordnung wiedergebenden Tabelle, erfolgt.

Hierdurch sind vorteilhafte Möglichkeiten der Kopplung zwischen Spannungsgrenze und Temperatur nutzbar. Besonders einfach und vorteilhaft ist dies erzielbar, wenn hierzu über ein Auslesen von strukturiert hinterlegten, beispielsweise durch Auslesen einer Tabelle verfügbaren, Messdaten mögliches Generieren von Signalen erfolgt.

Alternativ oder ergänzend kann das erfindungsgemäße Verfahren auch derart weitergebildet werden, dass zur Festlegung des ersten Wertes und des zweiten Wertes, auf Basis zumindest eines Teils der gemessenen Parameter des Zyklus und/oder eines unmittelbar benachbarten Zyklus, wie beispielsweise Ladungsmenge, Strom, Zeitpunkt, zur, insbesondere auf Grundlage einer Interpolation beruhenden, Generierung von Werten, die als weitere Werte der Parameter des Zyklus und/oder eines unmittelbar benachbarten Zyklus gespeichert werden, herangezogen werden.

Hierdurch werden die Signale für das HPC-Verfahren optimiert, insbesondere wird die Beziehung zwischen Ladungsmengen und anderen Parametern der Messungen für die Bilanzierung gemäß HPC-Verfahren erhalten und/oder dafür genutzt.

Eine weitere vorteilhafte Weiterbildung des erfindungsgemäßen Verfahrens ist gegeben, wenn der erste Wert und/oder der zweite Wert derart festgelegt wird, dass
a) der erste Wert und der zweite derart determiniert werden, dass für einen gemessenen und/oder manipulierten maximalen Spannungswert je Ladezyklus gilt, dass dessen Wert je Zyklus nicht kleiner ist als der erste Wert,
b) für einen gemessenen und/oder minimalen Spannungswert je Entladezyklus gilt, dass dessen Wert je Zyklus nicht größer ist als der zweite Wert,
c) die Anzahl der gemessenen und/oder manipulierten maximalen Spannungswerte, die den ersten Wert überschreiten und die Anzahl der beliebigen unteren Spannungswerte, die den zweiten Wert unterschreiten, auf ein Minimum reduziert wird.

Hierdurch ist ein einfacher, aber effektiver Ablauf für eine Maximierung von Zeitfenstern für nutzbare Spannungsverläufe gegeben. Neben den bereits genannten Weiterbildungen zur Realisierung dieser Wirkung, bietet auch diese Weiterbildung den Vorteil, dass hardwarebedingte Schwankungen, beispielsweise durch zu niedrige Auflösung während der Messung, insbesondere der Spannungswerte, eliminiert werden können.

Alternativ oder ergänzend kann das erfindungsgemäße Verfahren derart vorteilhaft weitergebildet werden, dass zu mindestens einem Zyklus
al) eine erste vergangene Zeit und/oder diesen Zeitpunkt Ordnungsbegriff, insbesondere Index, sowie für die zwei folgenden Zeitpunkte zumindest ein zum jeweiligen Zeitpunkt, insbesondere durch folgende zwei Indizes bestimmter, zugehöriger zumindest Teil der gemessenen Parameter, insbesondere die dem Batteriespeicher zugeführte Ladungsmenge, ermittelt wird, wenn in einem Ladezyklus der Spannungswert oberhalb des ersten Wertes liegt,
bl) die den Ordnungsbegriffen zugeordnete gemessene Ladungsmenge als einer der Parameter entnommen und jeweils für eine Ladungsbilanzierung, insbesondere nach dem HPC-Verfahren, gespeichert wird,
c1) die den Ordnungsbegriffen zugeordneten gemessenen Parameter gelöscht werden,
d1) mindestes zwei Spannungswerte generiert und als Parameter den gemessenen Werten derart eingefügt werden, dass der erste generierte Spannungswert den letzten Spannungswert des Ladezyklus und der zweite generierte Spannungswert, den ersten Spannungswert der Pause definiert,
a2) eine erste vergangene Zeit und/oder diesen Zeitpunkt Ordnungsbegriff, insbesondere Index, sowie für die zwei folgenden Zeitpunkte zumindest ein zum jeweiligen Zeitpunkt, insbesondere durch folgende zwei Indizes bestimmter, zugehöriger zumindest Teil der gemessenen Parameter, insbesondere die dem Batteriespeicher entnommene Ladungsmenge, ermittelt wird, wenn in einem Entladezyklus der Spannungswert unterhalb des zweiten Wertes liegt,
b2) die den Ordnungsbegriffen zugeordnete gemessene Ladungsmenge als einer der Parameter entnommen und jeweils für die Ladungsbilanzierung, insbesondere nach dem HPC-Verfahren, gespeichert wird,
c2) die den Ordnungsbegriffen zugeordneten gemessenen Parameter gelöscht werden,
d2) mindestes zwei Spannungswerte generiert und als Parameter den gemessenen Werten derart eingefügt werden, dass der erste generierte Spannungswert den letzten Spannungswert des Entladezyklus und der zweite generierte Spannungswert den ersten Spannungswert der Pause definiert.

Hierdurch ist ein einfacher und effizienter Ablauf zur erfindungsgemäßen Manipulation der Messungen bzw. der gemessenen Parameter gegeben.

Gemäß einer weiteren Weiterbildung des erfindungsgemäßen Verfahrens erfolgt das Verfahren computergestützt in einer Recheneinheit, so dass maximale Freiheitsgrade für Messungen, Signalverarbeitung und/oder Optimierung des Verfahrens bestehen.

Die in Bezug auf das erfindungsgemäße Verfahren und dessen bevorzugten Ausgestaltungen und Weiterbildungen angeführten Vorteile lassen sich dabei sinngemäß auf die erfindungsgemäße Vorrichtung übertragen und liegen zudem auch in der Tatsache, dass sie durch ihre Implementierung die Durchführung des Verfahrens erlauben.

Das Gleiche gilt auch für das erfindungsgemäße Computerprogrammprodukt.

Im Folgenden wird die Erfindung anhand der in den Figuren 1 bis 5 dargestellten Ausführungsbeispiele näher beschrieben und erläutert. Es zeigen:
- Figur 1: schematisch als ein Ausführungsbeispiel der erfindungsgemäßen Anordnung, eine Vorrichtung zum Bestimmen der Alterung eines Batteriespeichers mit einer Hoch-Präzisions-Coulometrie-Vorrichtung;
- Figur 2: schematisch ein Ablaufdiagram eines Ausführungsbeispiels des erfindungsgemäßen Verfahrens;
- Figur 3: Diagramme der Spannungs-, Strom und Ladungsverläufe aus Messungen und schematische Darstellung des Einfügens von Werten in Anwendung des Ausführungsbeispiels des erfindungsgemäßen Verfahrens;
- Figur 4: Diagramme der Spannungs-, Strom und Ladungsverläufe aus Messungen und schematische Darstellung des Einfügens von Werten, insbesondere der oberen Spannungsgrenze und abhängigen Werte, in Anwendung des Ausführungsbeispiels des erfindungsgemäßen Verfahrens; und
- Figur 5: Diagramme der gemessenen und modifizierten Spannung in Anwendung des Ausführungsbeispiels des erfindungsgemäßen Verfahrens.

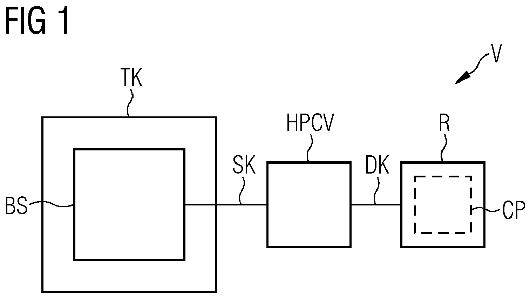

Bei den im Folgenden in den Figuren 1 bis 5 erläuterten Ausführungsbeispielen handelt es sich um bevorzugte Ausführungsformen und Weiterbildungen der Erfindung.

Insbesondere zeigen die nachfolgenden Ausführungsbeispiele lediglich beispielhafte Realisierungsmöglichkeiten, wie insbesondere solche Realisierungen der erfindungsgemäßen Lehre aussehen könnten, da es unmöglich und auch für das Verständnis der Erfindung nicht zielführend oder notwendig ist, all diese Realisierungsmöglichkeiten zu benennen.

Auch sind insbesondere einem (einschlägigen) Fachmann in Kenntnis des Vorrichtungsanspruchs und/oder der Verfahrensansprüche alle im Stand der Technik üblichen Möglichkeiten zur Realisierung der Erfindung selbstverständlich bekannt, sodass es insbesondere einer eigenständigen Offenbarung in der Beschreibung nicht bedarf.

Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind.

Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

Figur 1 zeigt ein mögliches Ausführungsbeispiel der erfindungsgemäßen Vorrichtung V zum Bestimmen und zum Setzen einer oberen Spannungsgrenze auf Basis der Ermittlung von Messdaten mit einer Hoch-Präzisions-Coulometrie-, HPC-Vorrichtung HPCV. Die Vorrichtung V umfasst einen Batteriespeicher BS, wobei der Batteriespeicher BS wenigstens eine Batteriezelle aufweist. Der Batteriespeicher BS ist in einer Temperierkammer TK angeordnet. Der Batteriespeicher BS ist über ein Stromkabel SK mit einer Hoch-Präzisions-Coulometrie-Vorrichtung HPCV verbunden. Die Hochpräzisions-Coulometrie-Vorrichtung HPCV ist wiederum mit einer Recheneinheit R über ein Datenkabel DK verbunden. Die Hochpräzisions-Coulometrie-Vorrichtung HPCV nimmt mit sehr großer Genauigkeit ein Ladungs-Zeit-Diagramm des Batteriespeichers BS auf. Der Batteriespeicher BS wird dabei mit periodischen Lastzyklen 100 zyklisch geladen und entladen. Die Messdaten werden der Rechnereinheit R übermittelt und von dieser gemäß einem auf der Rechnereinheit R eingespielten erfindungsgemäßen Computerprogrammprodukt CP bestimmten Prozessablaufs, einem Ausführungsbeispiel des erfindungsgemäßen Verfahrens folgend, weiterer Verarbeitung unterworfen.

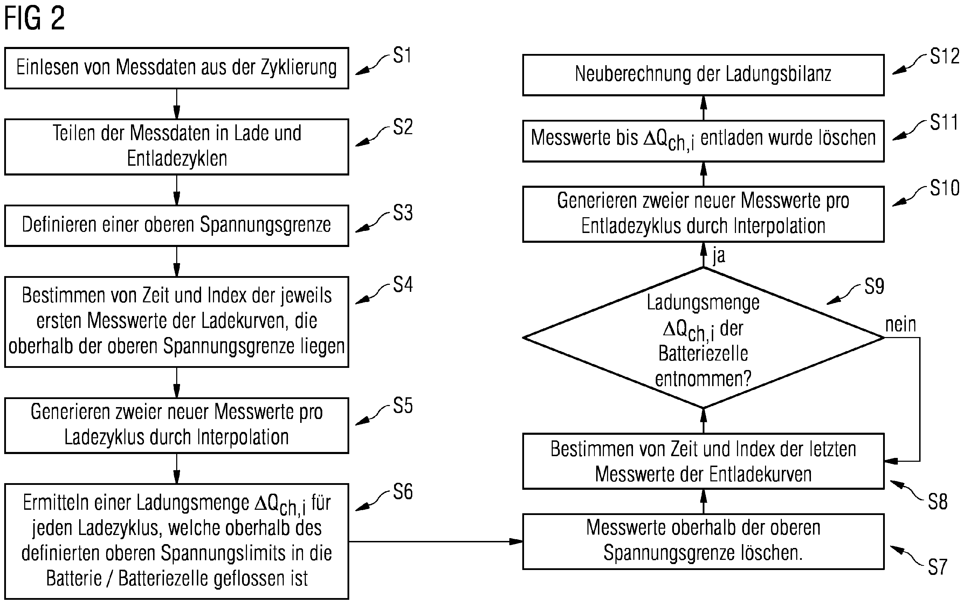

Als ein Ausführungsbeispiel des erfindungsgemäßen Verfahrens ist als ein Teil eines derartigen Prozessablaufs in Figur 2 der Ablauf zum Setzen einer oberen Spannungsgrenze und entsprechenden Manipulation von Messdaten dargestellt.

In einem ersten Schritt S1 erfolgt ein Einlesen von den gemäß Ausführungsbeispiel gemessenen Daten. Dabei handelt es sich zumindest um Messdaten aus einer Zyklierung mit mehreren Zyklen.

Es muss sich dabei nicht um eine HPC Vorrichtung HPCV bzw. eine Zyklierung im Rahmen eines HPC-Verfahrens handeln, vielmehr sind hier alle eingangs erwähnten Methoden, die eine Zyklierung zur Ermittlung von Batteriezuständen vollziehen, umfasst, solange sie die für die Erfindung notwendigen Messdaten ermitteln.

Ferner kann es von Vorteil sein dieses Ausführungsbeispiel derart weiterzubilden, dass die Messdaten der ersten Zyklen nicht eingelesen werden bzw. nicht verwandt werden, da in den ersten Zyklen ein Einschwingverhalten bestehen kann, das die Ergebnisse des Verfahrens, insbesondere der folgenden Schritte verfälschen kann.

Insoweit es sich um Messdaten handelt, werden die Messdaten gemäß einem zweiten Verfahrensschritt S2 nach Lade und Entladezyklen geteilt.

Neben dem Teilen erfolgt gemäß dem Ausführungsbeispiel des erfindungsgemäßen Verfahrens in einem dritten Schritt S3 ein Definieren einer oberen Spannungsgrenze.

Die obere Spannungsgrenze wird dabei gemäß dem Ausführungsbeispiel so gewählt, dass über einen festlegbaren Bereich der Messung, der analysiert werden soll, eine einheitliche Grenze möglich ist und gleichzeitig nur möglichst wenige Messdaten oberhalb dieser Grenze liegen.

In einem vierten Schritt S4 erfolgt ein Bestimmen von Zeit und Index der jeweils ersten Messwerte der Ladekurven, die oberhalb der gewählten, also festgelegten, oberen Spannungsgrenze liegen.

Ferner erfolgt in einem fünften Schritt S5 ein Generieren zweier neuer Messwerte pro Ladezyklus durch Interpolation.

Hierbei stellt gemäß dem Ausführungsbeispiel des erfindungsgemäßen Verfahrens der erste der beiden neuen Messwerte den letzten Messwert des Ladezyklus dar (Strom = Ladestrom). Der zweite neue Messwert stellt den ersten Messwert der Pause dar (Strom = 0).

In einem sechsten Schritt S6 erfolgt ferner ein Ermitteln einer Ladungsmenge ΔQch,i für jeden Ladezyklus, welche oberhalb der definierten oberen Spannungsgrenze in die Batterie/ Batteriezelle geflossen ist.

Gemäß einem siebten Schritt S7 erfolgt ein Löschen der Messwerte oberhalb der oberen Spannungsgrenze.

Ein weiterer, achter Verfahrensschritt S8 besteht darin, Zeit und Index der letzten Messwerte der Entladekurven zu bestimmen. Dies erfolgt als ein neunter Schritt S9 in Form einer Wiederholung so lange bis die Ladungsmenge ΔQch,i der Batterie/Batteriezelle entnommen wurde.

In einem zehnten Verfahrensschritt S10 wird ein Generieren zweier neuer Messwerte pro Entladezyklus durch Interpolation durchgeführt. Der erste der beiden neuen Messwerte stellt gemäß dem Ausführungsbeispiel des erfindungsgemäßen Verfahrens den letzten Messwert des Entladezyklus dar (Strom = Entladestrom). Der zweite neue Messwert stellt den ersten Messwert der Pause dar (Strom = 0).

Als ein weiterer, elfter Verfahrensschritt S11 ist gemäß dem Ausführungsbeispiel des erfindungsgemäßen Verfahrens vorgesehen, die Messwerte bis ΔQch,i entladen wurde, zu löschen.

In einem zwölften Schritt S12 erfolgt dann eine Neuberechnung der Ladungsbilanz.

Das Setzen einer unteren Spannungsgrenze erfolgt gemäß diesem Ausführungsbeispiel des erfindungsgemäßen Verfahrens mutatis mutandis, d.h. in sich für den Erfinder bei Betrachtung des oben dargelegten Vorgehens analogen Schritten, die ggf. einzeln angepasst an das Ziel, die untere Spannungsgrenze zu bestimmen, insbesondere bzgl. Lade-/Entladezyklus und -Richtung, vertauscht oder analog erfolgen.

Für einen Fachmann ist dabei klar, dass der dargestellte Ablauf nicht notwendigerweise in der dargestellten zeitlichen Reihenfolge erfolgen muss. Vielmehr handelt es sich bei den Schritten S1...S12 um Verfahrensschritte, die im Rahmen des Schutzbereichs der Ansprüche in jeder beliebigen zeitlichen Abfolge und Kombination mit gegebenenfalls notwendigen Anpassungen, beispielsweise gemäß den Weiterbildungen der Erfindung, durchgeführt werden können und das beschriebene Einfügen als Ergebnis haben, so dass die entstehenden Werte dem HPC-Verfahren zugeführt werden.

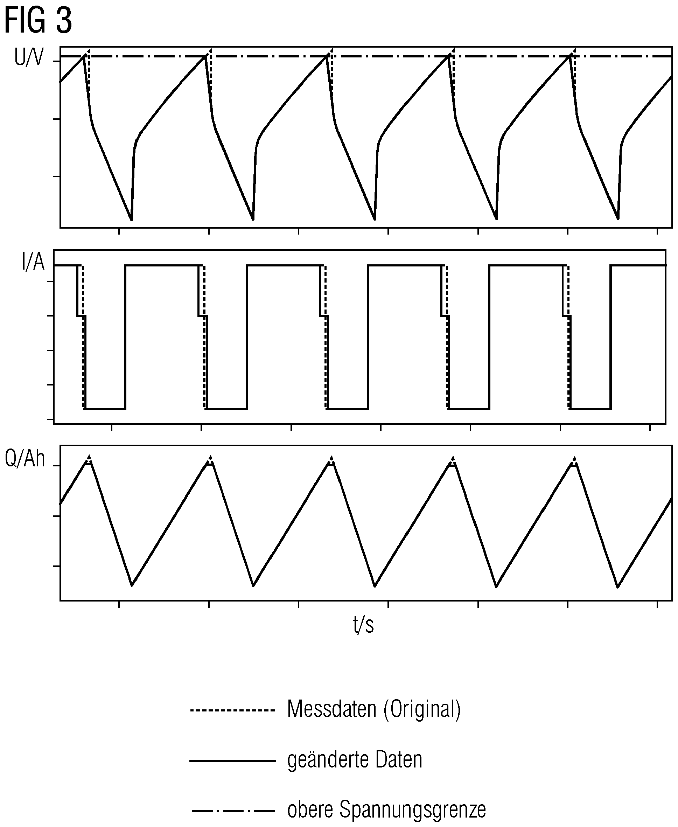

Eine Illustration des Einfügens der oberen Spannungsobergrenze gemäß beschriebenem Ausführungsbeispiel des erfindungsgemäßen Verfahrens ist in der Figur 3 gezeigt.

Dabei sind die ursprünglichen Messdaten als volle Linie, die gemäß Ausführungsbeispiel definierte obere Spannungsgrenze als gepunktete Linie und die gemäß Ausführungsbeispiel des Verfahrens geänderten Daten als strichpunktierte Linie dargestellt.

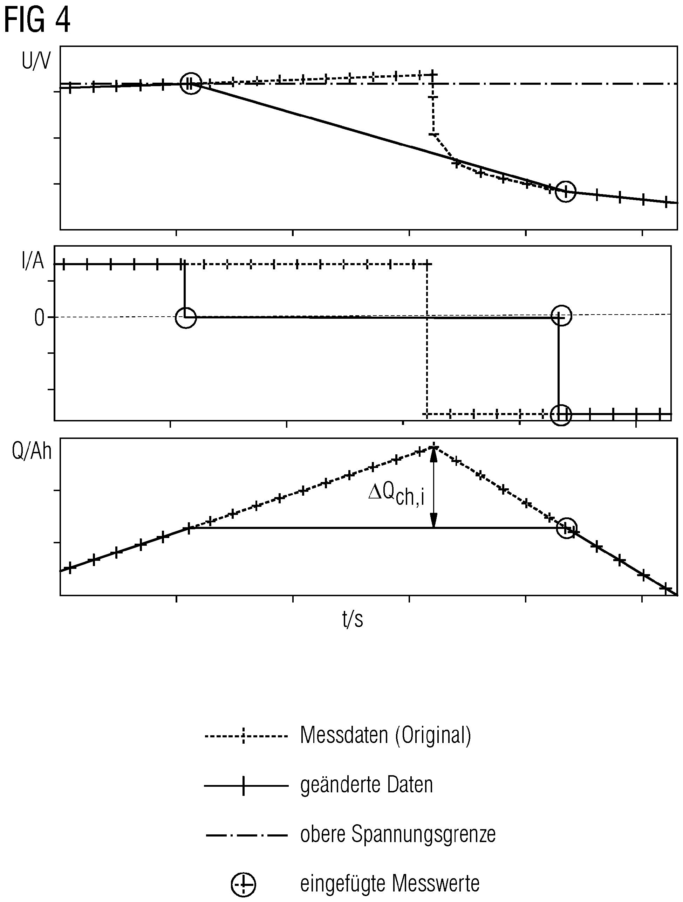

Etwas detaillierter ist das Einfügen in der Figur 4 dargestellt. Zu sehen ist dort eine vergrößerte Darstellung zur Illustration des Einfügens der oberen Spannungsgrenze gemäß Ausführungsbeispiel des erfindungsgemäßen Verfahrens.

Zu sehen sind drei Diagramme, wobei im obersten, ersten Diagramm die gemäß erfindungsgemäßem Verfahren neu eingefügten Messwerte ab dem Schnittpunkt der Ladekurve mit der oberen Spannungsgrenze zu erkennen sind, das mittlere, zweite Diagramm den Verlauf der Ladungsmenge ΔQch,i, wie sie sich beim Einsatz des Ausführungsbeispiels des erfindungsgemäßen Verfahrens darstellt, aufzeigt und schließlich im unteren, dritten Diagramm die gemäß dem Ausführungsbeispiel des erfindungsgemäßen Verfahrens neu eingefügten Messwerte bei Unterschreiten der Ladungsmenge ΔQch,i in der Entladekurve zu erkennen sind.

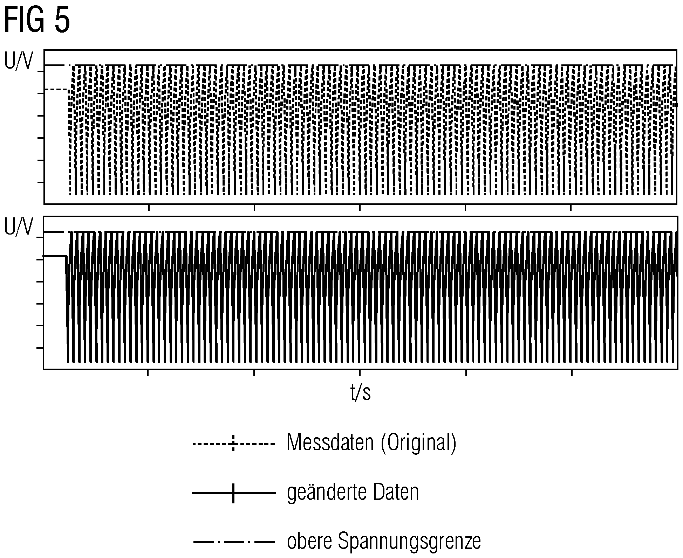

Die Abbildung in der Figur 5 zeigt nun schließlich einen Vergleich der Messdaten, konkret des Spannungsverlaufs wie er gemessen würde mit dem Verlauf wie er sich ergibt, wenn der obere Spannungswert gemäß Ausführungsbeispiel der Erfindung festgelegt wird. Im oberen, ersten Diagramm, sind also die originalen Spannungswerte, die somit kein konstantes oberes Spannungslimit aufweisen, punktiert dargestellt. Dies ist daran zu erkennen, dass die Spannungsspitzen über das erfindungsgemäß festgelegte Spannungslimit - als strichpunktierter Strich dargestellt - gehen.

In dem unteren, zweiten Diagramm sind mit den erfindungsgemäß in diese Originaldaten gemäß Ausführungsbeispiel des erfindungsgemäßen Verfahrens eingefügten modifizierten Spannungswerten (volle Linie) für das HPC-Verfahren bereitgestellte Werte dargestellt, die durch die erfindungsgemäße Verfahrensweise sicherstellen, dass die ebenfalls eingezeichnete definierte obere Spannungsgrenze (strichpunktierte Linie) nicht überschritten wird.

Das Setzen einer unteren Spannungsgrenze erfolgt mutatis mutandis, d.h. analog und umgekehrt.

Die beschriebene Erfindung erlaubt eine genauere und robustere Bestimmung von mit der HPC Methode bestimmten Alterungsraten von Batterien.

Der verwendete Algorithmus ist in der Lage, die Qualität der verwendeten Daten positiv zu beeinflussen. Dadurch können zur Bestimmung der Alterungsrate von Batterien mit der HPC Methode auch Daten verwendet werden, die ursprünglich nicht zu diesem Zweck erzeugt wurden und die zunächst nicht die geforderte Genauigkeit aufweisen.

Zudem existieren umfangreiche Datensammlungen aus Messreihen zur Bestimmung der Batteriealterung, wobei die Bestimmung der Batteriealterung nach der konventionellen Methode durchgeführt wurde. Bei der konventionellen Methode werden Batteriezellen bei verschiedenen Arbeitspunkten zykliert und in bestimmten Abständen Checkup Messungen durchgeführt.

Im Gegensatz zur HPC-Methode werden die Alterungsraten aus den Checkup Messungen und nicht aus den Zyklierungen selbst bestimmt. Die Messdaten aus den Zyklierungen werden in der Regel nicht ausgewertet, obwohl sehr viel Information über die Batteriealterung in diesen Daten versteckt ist. Die aus der konventionellen Bestimmung von Alterungsraten gewonnenen Zyklierungsdaten genügen in der Regel nicht den Anforderungen der HPC Methodik und lassen sich deshalb nicht direkt für HPC Auswertungen nutzen.

Die Bestimmung der Alterungsraten erfolgt üblicherweise nach der klassischen Methode (Zyklierung und CheckUp im Wechsel).

In anderen Worten lassen sich einige Vorteile der Erfindung wie folgt aufzählen:
- Die Erfindung beschreibt ein Verfahren und eine Anordnung, bei denen der Messdaten aus der Zyklierung von Batterien dahingehend verändert, dass die Daten in vorteilhafter Weise für HPC-Analysen genutzt werden können. Bevorzugte Ausführungsbeispiele und Weiterbildungen der Erfindung erlauben es, die Spannungsgrenzen, zwischen denen die Batterie zykliert wurde, für die Auswertung neu zu setzen.
- Die Erfindung kann angewendet werden, um Messdaten aus der Zyklierung von Batterien, bei denen keine festen Spannungsgrenzen eingehalten wurden, zu konvertieren, so dass daraus mit Hilfe des HPC-Algorithmus eine Alterungsrate der Batterie bestimmt werden kann.
- Die Erfindung kann auch genutzt werden, um hardwarebedingte, beispielsweise durch zu niedrige Auflösung der Spannungsmessung bedingte, Schwankungen der Spannungsgrenzen) zu eliminieren.
- Die Erfindung kann auch angewendet werden, um nachteilige Temperatureinflüsse zu kompensieren. In diesem Fall bieten sich Weiterbildungen und Ausführungsbeispiele der Erfindung an, in denen die Spannungsgrenze für jeden Zyklus individuell gesetzt und an die gemessene Zelltemperatur gekoppelt wird. Temperaturbedingte Änderungen in der Überspannung können dadurch ausgeglichen werden. Die Kopplung zwischen Spannungsgrenze und Temperatur kann vorteilhafterweise über eine Tabelle, in der der Gleichstrom-Innenwiderstand in Abhängigkeit von der Stromrichtung, dem SOC und der Temperatur gespeichert ist, erfolgen.
- Obere und untere Spannungsgrenzen können gemäß Ausführungsbeispielen und Weiterbildungen der Erfindung alternativ oder ergänzend manuell gesetzt werden.
- Das Spannungsfenster kann gemäß Ausführungsbeispielen und Weiterbildungen der Erfindungen vorteilhafterweise aber auch so gewählt werden, dass es das größtmögliche Spannungsfenster darstellt, d.h. die obere Spannungsgrenze/untere Spannungsgrenze wird nur so weit herabgesetzt/angehoben, dass die Messdaten über den auszuwertenden Bereich gemeinsame Spannungsgrenzen aufweisen.
- Um das nutzbare Spannungsfenster möglichst groß ausbilden zu können, kann gemäß Ausführungsbeispielen und Weiterbildungen der Erfindung der erste Teil der aufgezeichneten Messdaten aus der Zyklierung, beispielsweise die erste Hälfte oder die ersten zwei Drittel, verworfen werden. Im ersten Teil der Messdaten, der hier abgeschnitten wird, befindet sich die Zelle in einem Einschwingverhalten, so dass der letzte Teil der Messung die eigentlich aussagekräftigen Daten und verlässlichere Werte bei der Altersratenbestimmung liefert.

## Patentansprüche

1. Verfahren zur Ermittlung der Alterung eines Batteriespeichers mittels zumindest teilweiser Nutzung des "Hoch-Präzisions-Coulometrie"-, HPC-Verfahrens, umfassend mehrere Schritte:
a) Durchlaufen mindestens zweier Zyklen einer Zyklierung zur Ermittlung von Zuständen, insbesondere der Alterung, des Batteriespeichers zur Messung von Parametern innerhalb der Zyklen in der zeitlich ersten Phase,
b) Manipulieren von durch die über die Zyklen gemessenen Parameter gebildeten Messdaten in einer zweiten Phase derart, dass zumindest ein Teil der Messdaten zumindest eines Teils der Zyklen hinsichtlich von zumindest teilweise mit einer oberen Spannungsgrenze und einer untere Spannungsgrenze korrelierenden Parameter, insbesondere die obere Spannungsgrenze und untere Spannungsgrenze selbst, innerhalb der Zyklen derart verändert werden, dass über alle Zyklen des Teils der Zyklen hinweg ein erster Wert der oberen Spannungsgrenze nahezu nie überschritten und ein zweiter Wert der unteren Spannungsgrenze nahezu nie unterschritten wird,
c) Bilden eines generierten Messdatensatzes für den Teil der Zyklen derart, dass veränderte zumindest teilweise korrelierende Parameter des manipulierten Teils der Messdaten und der nicht manipulierte Teil der Messdaten des Teils der Zyklen zusammengeführt werden.
d) Erzeugung von, die Werte der generierten Messdaten repräsentierenden, Signalen zu einer Verarbeitung unter Nutzung des HPC Verfahrens,
e) Ermittlung der Alterung auf Grundlage der Verarbeitung zumindest der die Werte der generierten Messdaten repräsentierenden Signale.

2. Verfahren nach dem vorhergehenden Anspruch,
**dadurch gekennzeichnet, dass** der Teil der Messdaten aus den durch die über die Zyklen gemessenen Parameter gebildeten Messdaten derart abgezweigt wird, dass ein dem Teil zeitlich vorausgehender, insbesondere aufgrund eines Einschwingens bezüglich mindestens einem der Parameter hinsichtlich seiner Werte stark schwankender Teil, der durch die über die Zyklen gemessenen Parameter gebildeten Messdaten, ausgenommen wird.

3. Verfahren nach dem vorhergehenden Anspruch,
**dadurch gekennzeichnet, dass** der erste Wert und der zweite Wert durch die Erfassung einer Nutzereingabe festgelegt wird.

4. Verfahren nach einem der vorhergehenden Ansprüche, **dadurch gekennzeichnet, dass** der erste Wert und der zweite Wert durch ein die Manipulation durchführendes Modul generiert wird.

5. Verfahren nach einem der vorhergehenden Ansprüche, **dadurch gekennzeichnet, dass** eine Festsetzung des ersten Wertes und des zweiten Wertes derart erfolgt, dass sie in Abhängigkeit der gemessenen Temperatur mindestens einer der Zellen, des Batteriespeichers, insbesondere individuell für jeden Zyklus, generiert werden.

6. Verfahren nach dem vorhergehenden Anspruch,
**dadurch gekennzeichnet, dass** die Festlegung in Abhängigkeit der Temperatur zumindest anhand einer eine Abhängigkeit des Gleichstrom-Innenwiderstandes der Zelle von der Stromrichtung, von dem SOC und/oder der Temperatur, insbesondere unter Auslesen einer diese Zuordnung wiedergebenden Tabelle, erfolgt.

7. Verfahren nach einem der vorhergehenden Ansprüche, **dadurch gekennzeichnet, dass** zur Festlegung des ersten Wertes und des zweiten Wertes, auf Basis zumindest eines Teils der gemessenen Parameter des Zyklus und/oder eines unmittelbar benachbarten Zyklus, wie beispielsweise Ladungsmenge, Strom, Zeitpunkt, zur, insbesondere auf Grundlage einer Interpolation beruhenden, Generierung von Werten, die als weitere Werte der Parameter des Zyklus und/oder eines unmittelbar benachbarten Zyklus gespeichert werden, herangezogen werden.

8. Verfahren nach einem der vorhergehenden Ansprüche, **dadurch gekennzeichnet, dass** der erste Wert und/oder der zweite Wert derart festgelegt wird, dass
a) der erste Wert und der zweite derart determiniert werden, dass für einen gemessenen und/oder manipulierten maximalen Spannungswert je Ladezyklus gilt, dass dessen Wert je Zyklus nicht kleiner ist als der erste Wert,
b) für einen gemessenen und/oder minimalen Spannungswert je Entladezyklus gilt, dass deren Wert je Zyklus nicht größer ist als der zweite Wert,
c) die Anzahl der gemessenen und/oder manipulierten maximalen Spannungswerte, die den ersten Wert überschreiten, und die Anzahl der beliebigen unteren Spannungswerte, die den zweiten Wert unterschreiten, auf ein Minimum reduziert wird.

9. Verfahren nach einem der vorhergehenden Ansprüche, **dadurch gekennzeichnet, dass** zu mindestens einem Zyklus al) eine erste vergangene Zeit und/oder ein diesen Zeitpunkt bestimmender Ordnungsbegriff, insbesondere Index, sowie für die zwei folgenden Zeitpunkte zumindest ein zum jeweiligen Zeitpunkt, insbesondere durch folgende zwei Indizes bestimmter, zugehöriger zumindest Teil der gemessenen Parameter, insbesondere die dem Batteriespeicher zugeführte Ladungsmenge, ermittelt wird, wenn in einem Ladezyklus der Spannungswert oberhalb des ersten Wertes liegt,
bl) die den Ordnungsbegriffen zugeordnete gemessene Ladungsmenge als einer der Parameter entnommen und jeweils für eine Ladungsbilanzierung, insbesondere nach dem HPC-Verfahren, gespeichert wird,
c1) die den Ordnungsbegriffen zugeordneten gemessenen Parameter gelöscht werden,
dl) mindestes zwei Spannungswerte generiert und als Parameter den gemessenen Werten derart eingefügt werden, dass der erste generierte Spannungswert den letzten Spannungswert des Ladezyklus und der zweite generierte Spannungswert den ersten Spannungswert der Pause definiert,
a2) eine erste vergangene Zeit und/oder ein diesen Zeitpunkt bestimmender Ordnungsbegriff, insbesondere Index, sowie für die zwei folgenden Zeitpunkte zumindest ein zum jeweiligen Zeitpunkt, insbesondere durch folgende zwei Indizes bestimmter, zugehöriger zumindest Teil der gemessenen Parameter, insbesondere die dem Batteriespeicher entnommene Ladungsmenge, ermittelt wird, wenn in einem Entladezyklus der Spannungswert unterhalb des zweiten Wertes liegt,
b2) die den Ordnungsbegriffen zugeordnete gemessene Ladungsmenge als einer der Parameter entnommen und jeweils für die Ladungsbilanzierung, insbesondere nach dem HPC-Verfahren, gespeichert wird,
c2) die den Ordnungsbegriffen zugeordneten gemessenen Parameter gelöscht werden,
d2) mindestes zwei Spannungswerte generiert und als Parameter den gemessenen Werten derart eingefügt werden, dass der erste generierte Spannungswert den letzten Spannungswert des Entladezyklus und der zweite generierte Spannungswert den ersten Spannungswert der Pause definiert.

10. Verfahren nach einem der vorhergehenden Ansprüche,
wobei das Verfahren computergestützt in einer Recheneinheit erfolgt.

11. Vorrichtung zum Durchführen des Verfahrens nach einem der Ansprüche 1 bis 10,
umfassend Mittel, insbesondere zumindest ein Modul, zur Durchführung des Verfahrens.

12. Computerprogrammprodukt, welches direkt in einen Speicher einer programmierbaren Recheneinheit ladbar ist, mit Programmcode-Mitteln, um ein Verfahren nach einem der Ansprüche 1 bis 10 auszuführen, wenn das Computerprogrammprodukt in der Recheneinheit ausgeführt wird.
